(19) Europäisches Patentamt
European Patent Office
Office européen des brevets

(11) Veröffentlichungsnummer : **0 277 915 B1**

(12) # EUROPÄISCHE PATENTSCHRIFT

(45) Veröffentlichungstag der Patentschrift :
**04.09.91 Patentblatt 91/36**

(51) Int. Cl.$^5$ : **C08F 2/50,** G03F 7/004,
G03F 7/027, G03F 7/038

(21) Anmeldenummer : **88810044.3**

(22) Anmeldetag : **27.01.88**

(54) **Photoinitiatorengemische enthaltend ein Titanocen und ein 3-Ketocoumarin.**

(30) Priorität : **02.02.87 CH 360/87**

(43) Veröffentlichungstag der Anmeldung :
**10.08.88 Patentblatt 88/32**

(45) Bekanntmachung des Hinweises auf die Patenterteilung :
**04.09.91 Patentblatt 91/36**

(84) Benannte Vertragsstaaten :
**DE FR GB IT NL SE**

(56) Entgegenhaltungen :
**EP-A- 0 119 162**
**EP-A- 0 186 626**
**EP-A- 0 242 330**
**FR-A- 2 339 881**

(73) Patentinhaber : **CIBA-GEIGY AG**
**Klybeckstrasse 141**
**CH-4002 Basel (CH)**

(72) Erfinder : **Rohde, Ottmar, Dr.**
**Bärenfelserstrasse 34**
**CH-4057 Basel (CH)**
Erfinder : **Schaffner, Armin**
**Le Chablais**
**CH-1588 Cudrefin (CH)**
Erfinder : **Riediker, Martin, Dr.**
**Gstaltenrainweg 75**
**CH-4125 Riehen (CH)**
Erfinder : **Meier, Kurt, Dr.**
**Im Kirschgarten 35**
**CH-4102 Binningen (CH)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**EP 0 277 915 B1**

Jouve, 18, rue Saint-Denis, 75001 PARIS

**Beschreibung**

Die vorliegende Erfindung betrifft Photoinitiatorengemische enthaltend eine Titanocen und ein 3-Ketocoumarin, strahlungsempfindliche Zusammensetzungen enthaltend ein ethylenisch ungesättigtes Monomeres und besagtes Photoinitiatorengemische, eine Verfahren zur Herstellung von thermostabilen Beschichtungen oder Reliefabbildungen sowie die Verwendung bestagter Zusammensetztungen in Abbildungsverfarhren auf streuenden oder stark reflektierenden Substraten.

Titanoceninitiatoren für die Photopolymerisation von ethylenisch ungesättigten Verbindungen sind aus den EP-A 122,223 und 186,626 bekannt. Nach der EP-A 186,626 lässt sich die Lichtempfindlichkeit ausgewählter Titanoceninitiatoren durch die Zugabe von üblichen Sensibilisatoren, wie beispielsweise von mono- oder polycyclischen Kohlenwasserstoffen, Phenonen, Xanthonen oder Thioxanthonen, steigern.

Strahlunsempfindliche Beschichtungen enthaltend vernetzbare Polymervorläufer, ausgewählte Titanoceninitiatoren und gegebenenfalls einen niedermolekularen Comonomerbaustein sind aus der EP-A 119,162 bekannt. Nach der Beschreibung kann man diesen Zusammensetzungen übliche Zuschlagstoffe, wie Sensibilisatoren oder Initiatoren, zusetzen.

In 3-Stellung substituiere Coumarine, darunter auch 3-Ketocoumarine, und deren Verwendung zum Sensibilisieren lichtempfindlicher Verbindungen sind aus der DE-OS 2704368 bekannt.

Bei der Photopolymerisation mit Titanocen-Initiatoren kommt es auf reflektierenden oder stark lichtstreuenden Substraten, beispielsweise auf Metall- oder Keramiksubstraten, zu einem Streuungsproblem, d.h. die Auflösung wird durch reflektiertes oder gestreutes Licht stark reduziert, da Licht in die geometrischen Schattenbereiche vordringt und dort eine Vernetzung der strahlungsempfindlichen Polymeren bewirkt.

Es wurde jetzt gefunden, das man durch Beigabe von 3-Ketocoumarinen in relativ geringer Konzentration dieses Streuungsproblem lösen kann, ohne die hohe Photoempfindlichkeit des Systems zu reduzieren.

Ausserdem lässt sich durch Zugabe von 3-Ketocoumarinen in unterschiedlichen Mengen der sogenannte Kantenwinkel von Reliefstrukturen beeinflussen, was bei alleiniger Verwendung des Titanoceninitiators in der Regel nicht möglich ist. Bei dünnen Schichten lässt sich darüber hinaus noch eine Steigerung der allgemeinen Photoempfindlichkeit, bezogen auf das Titanocensystem, beobachten.

Die vorliegende Erfindung betrifft Zusammensetzungen enthaltend

a) einen Titanocen-Photoinitiator der Formel I

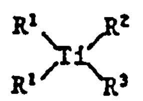

(I), und

und

b) ein 3-Ketocoumarin der Formel II

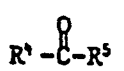

(II),

worin beide $R^1$ unabhängig voneinander unsubstituiertes oder durch $C_1$-$C_8$Alkyl oder $C_1$-$C_8$Alkoxy substituiertes Cyclopentadienyl$^{\ominus}$, Indenyl$^{\ominus}$, 4,5,6,7-Tetrahydroindenyl$^{\ominus}$ oder zusammen einen Rest der Formel III darstellen

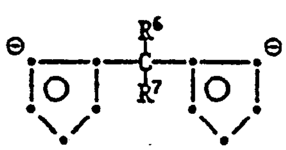

(III),

wobei $R^6$ und $R^7$ unabhängig voneinander Wasserstoff oder Methyl bedeuten, $R^2$ einen 6-gliedrigen carbocyclischen-aromatischen Ring oder einen 5- oder 6-gliedrigen heterocyclischen-aromatischen Ring bedeutet, der in mindestens einer der beiden Orthostellungen zur Metallkohlenstoffbindung durch eine Fluoratom oder durch eine Gruppe —$CF_2R$ substituiert ist, wobei R für ein Fluoratom oder für Methyl steht, $R^3$ eine der Bedeutungen von $R^2$ besitzt oder zusätzlich für Halogen, Pseudohalogen, —$OR^8$ oder —$SR^9$ steht, wobei $R^8$ Wasserstoff,

$C_1$-$C_6$Alkyl, Phenyl, Acetyl oder Trifluoracetyl ist und $R^9$ $C_1$-$C_6$Alkyl oder Phenyl bedeutet, oder $R^2$ und $R^3$ zusammen einen Rest der Formel IV bilden

—Q-Y-Q—

worin Q für einen 6-gliedrigen carbocyclishen-aromatischen oder 5-oder 6-gliedrigen heterocyclishen-aromatischen Rest steht, wobei die beiden Bindungen jeweils in Orthostellung zur Brücke Y stehen und die Metastellung zur Brücke Y jeweils durch eine Fluoratom oder eine Gruppe —$CF_2R$ substituiert ist und Y eine direkte Bindung, —O—, —S—, —$SO_2$—, —CO—, —$CH_2$— oder —$C(CH_3)_2$— darstellt, $R^4$ ein Rest der Formel V ist

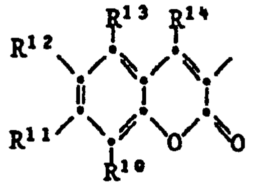

(V),

$R^5$ $C_1$-$C_{20}$Alkyl, Cycloalkyl mit 5-7 Ringkohlenstoffatomen, gegebenenfalls durch ein bis drei $C_1$-$C_6$Alkylgruppen, $C_1$-$C_6$Alkoxygruppen oder Halogenatome oder durch eine Diphenylamino- oder $C_1$-$C_6$Dialkylaminogruppe substituiertes Phenyl oder Naphthyl, $C_7$-$C_9$Aralkyl, ein Rest

$$-(CH=CH)_a-C_6H_5$$

oder eine Rest der Formel V ist, a 1 oder 2, vorzugsweise 1, bedeutet, $R^{10}$, $R^{11}$, $R^{12}$, $R^{13}$ und $R^{14}$ unabhängig voneinander Wasserstoff, $C_1$-$C_6$Alkyl, $C_1$-$C_6$Alkoxy, Phenyl, Tolyl, Xylyl oder Benzyl sind, und $R^{11}$ zusätzlich noch eine Gruppe —$NR^{15}R^{16}$ oder —$OR^{15}$ sein kann, worin $R^{15}$ und $R^{16}$ unabhängig voneinander Wasserstoff oder $C_1$-$C_6$Alkyl sind und wobei ferner gilt, dass zwei oder drei der Reste $R^{10}$, $R^{11}$, $R^{12}$ und $R^{13}$ zusammen mit den Ringkohlenstoffatomen an denen sie sitzen einen ankondensierten Ring mit 5- oder 6-Ringatomen oder eine ankondensiertes Ringsystem mit 5- oder 6-gliedrigen Ringen bilden können.

Als substituierter Rest trägt $R^1$ $C_1$-$C_6$Alkyl- oder -Alkoxyreste. Die Substituenten können geradkettig oder verzweigt sein. Bevorzugt werden geradkettige Substituenten. Beispeile für Substituenten sind Methyl, Ethyl, n-Propyl, sek.-Propyl, n-Butyl, sek.-Butyl, n-Pentyl, n-Hexyl, Methoxy, Ethoxy, n-Propyloxy, sek.-Propyloxy, n-Butyloxy, sek.-Butyloxy, n-Pentyloxy oder n-Hexyloxy. Bevorzugt werden Methyl oder Methoxy, insbesondere Methyl.

$R^1$ trägt als substituierter Rest vorzugsweise einen oder zwei Substituenten, ganz besonders bevorzugt jedoch einen Substituenten.

Bevorzugte Reste $R^1$ sind die unsubstituierten Typen. Beispiele für ganz besonders bevorzugter Reste $R^1$ sind Cyclopentadienyl oder Methylcylopentadienyl.

$R^6$ und $R^7$ sind vorzugsweise beide Wasserstoff oder beide Methyl, insbesondere jedoch beide Wassertoff.

Bei $R^2$ als 6-gliedriger carbocylischer-aromatischer Ring handelt es sich beispielsweise um Inden, Indan, Fluoren, Naphthalin und besonders um Phenyl. Dieser Ring muss definitionsgemäss in mindestens einer Orthostellung zur Metall-Kohlenstoffbindung einen Fluorsubsituenten tragen. Vorzugsweise handelt es sich dabei um ein Fluoratom oder um —$CF_3$. Bevorzugt sind beide Orthostellungen zur Metall-Kohlenstoffbindung durch einen Fluorsubstituenten substituiert.

Beispiele für bevorzugte Gruppen $R^2$ sind 4,6-Difluorinden-5-yl, 4,6-Bis-(trifluormethyl)-inden-5-yl, 5,7-Difluorind-6-yl, 5,7-Bis-(trifluormethyl)-ind-6-yl, 2,4-Difluorfluoren-3-yl, 2,4-Bis-(trifluormethyl)-fluoren-3-yl, 1,3-Difluornaphth-2-yl, 1,3-Bis-(trifluormethyl)-naphth-2-yl und ganz besonders 2,6-Difluorphen-1-yl und 2,6-Bis-(trifluormethyl)-phen-1-yl.

Als heterocyclischer-aromatischer 5-gliedriger Ring enthält $R^2$ vorzugsweise eine Heteroatom und als 6-gliedriger Ring bevorzugt 1 oder 2 Heteroatome. Beispiele für solche mit Fluoratomen oder —$CF_2R$ Gruppen, insbesondere —$CF_3$ Gruppen, substituierten Ringe sind 2,4-Difluorpyrr-3-yl, 2,4-Bis-(trifluormethyl)-pyrr-3-yl, 2,4-Difur-3-yl, 2,4-Bis-(trifluormethyl)-fur-3-yl, 2,4-Difluorthiophen-3-yl, 2,4-Bis-(trifluormethyl)-thiophen-3-yl, 2,4-Difluorpyrid-3-yl, 2,4-Bis-(trifluormethyl)-pyrid-3-yl, 4,6-Difluorpyrimid-5-yl oder 4,6-Bis-(trifluormethyl)-pyrimid-5-yl.

Als Halogen bedeutet $R^3$ Fluor, Chlor, Brom oder Iod. Bevorzugt werden Chlor oder Brom.

Als Pseudohalogen bedeutet $R^3$ beispielsweise Cyanat, Thiocyanat, Azid oder Cyanid.

Bei $R^8$ oder $R^9$ als $C_1$-$C_6$Alkyl handelt es sich um verzweigte oder bevorzugt um geradkettige Reste. Beispiele dafür sind Methyl, Ethyl, n-Propyl, sek.-Propyl, n-Butyl, sek.-Butyl, n-Pentyl oder n-Hexyl. Bevorzugt wird Methyl.

Bilden $R^2$ und $R^3$ zusammen einen Rest der Formel IV, so handelt es sich dabei vorzugsweise um die Gruppen der Formeln IVa, IVb, IVc, IVd, IVe oder IVf

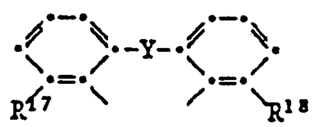 (IVa)

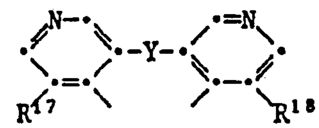 (IVb)

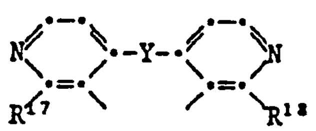 (IVc)

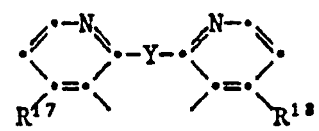 (IVd)

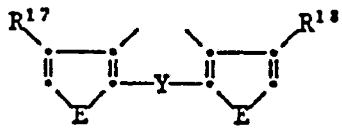 (IVe)

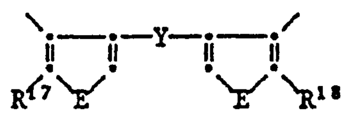 (IVf)

worin $R^{17}$ und $R^{18}$ unabhängig voneinander ein Fluoratom oder eine Gruppe —$CF_2R$, wie oben definiert, bedeuten, Y die weiter oben definierte Bedeutung besitzt und E —O—, —S— oder —NH— ist.

Bei $R^5$ als $C_1$-$C_{20}$Alkyl handelt es sich um verzweigte oder bevorzugt um geradkettige Alkylreste. Beispiele dafür sind Methyl, Ethyl, n-Propyl, sek.-Propyl, n-Butyl, sek-Butyl, n-Pentyl, n-Hexyl, n-Heptyl, n-Octyl, n-Nonyl, n-Decyl, n-Dodecyl, n-Tetradecyl, n-Hexadecyl, n-Octadecyl oder n-Eicosyl.

Bevorzugte Alkylreste $R^5$ sind geradkettig und weisen 1 bis 6 C-Atome auf. Ganz besonders bevorzugt wird Methyl.

Bei $R^5$ als Cycloalkyl mit 5-7 Ringkohlenstoffatomen handelt es sich um Cyclopentyl, Cyclohexyl oder Cycloheptyl. Bevorzugt wird Cyclohexyl.

Beispiele für alkylsubstituierte Naphthyl- oder Phenylgruppen $R^5$ sind o-, m- oder p-Tolyl, Xylyl, Ethylphenyl oder 2-Methylnaphthyl.

Beispiele für alkoxysubstituierte Naphthyl- oder Phenylgruppen sind o-, m- oder p-Methoxyphenyl, Dimethoxyphenyl oder 2-Methoxynaphthyl.

Beispiele für halogensubstituierte Naphthyl oder Phenylgruppen sind o-, m- oder p-Chlorphenyl, Dichlorphenyl oder 2-Chlornaphthyl. Beispiele für diphenylamino- oder dialkylaminosubstituierte Naphthyl- oder Phenylgruppen sind 4-(N,N-Diphenylamino)-phenyl oder 2-(N,N-Diphenylamino)-naphthyl oder die entsprechenden N,N-Dimethylaminoderivate.

Beispiele für $C_7$-$C_9$Aralkyl sind Benzyl, α-Methylbenzyl oder α,α-Dimethylbenzyl, Bevorzugt wird Benzyl.

Sind die Gruppen $R^{10}$ bis $R^{14}$ $C_1$-$C_6$Alkyl oder $C_1$-$C_6$Alkoxy, so handelt es sich dabei beispielsweise um die weiter oben als Substituenten für $R^1$ aufgezählten Reste.

Bevorzugt sind diese Reste Methyl oder Methoxy.

Sind die Gruppen $R^{15}$ und $R^{16}$ $C_1$-$C_6$-Alkyl, so handelt es sich dabei beispielsweise um die vorstehend für $R^1$ angegebenen Reste. Bevorzugt handelt es sich um Ethyl, n-Propyl, sek.Propyl, n-Butyl, sek.Butyl, n-Pentyl oder n-Hexyl, insbesondere um Ethyl.

Bilden zwei oder drei der Reste $R^{10}$, $R^{11}$, $R^{12}$ oder $R^{13}$ einen 5- oder 6-gliedrigen Ring oder ein Ringsystem, so handelt es sich in der Regel um einen carbocyclisch-aromatischen oder um einem carbocyclisch-nichtaromatischen Ring oder eine Ringsystem. Im Falle von $R^{11}$ = —$OR^{15}$ oder —$NR^{15}R^{16}$ kann es sich auch um einem heterocyclischen Ring oder ein Ringsystem handeln. Bevorzugt werden 6-gliedrige heterocyclische Ringe oder Ringsystem. Ein Beispiel für einen Rest $R^4$ enthaltend ein Ringsystem dieses Typs ist

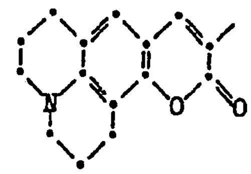

Bevorzugte Titanoceninitiatoren sind Verbindungen der Formel I, worin $R^1$ unabhängig voneinander unsubstituiertes oder mit ein oder zwei Methylgruppen substituiertes Cyclopentadienyl bedeuten, $R^2$ und $R^3$ unabhängig voneinander einen Rest der Formel VI darstellen

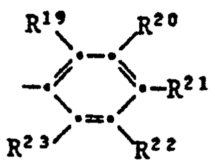
(VI),

worin $R^{19}$ ein Fluoratom oder eine Gruppe —$CF_2R$, wie oben definiert ist, $R^{20}$, $R^{21}$, $R^{22}$ und $R^{23}$ unabhängig voneinander ein Fluoratom, eine Gruppe —$CF_2R$, Wasserstoff, $C_1$-$C_6$Alkyl oder $C_1$-$C_6$Alkoxy sind oder $R^2$ und $R^3$ zusammen eine Gruppe der Formel IVa, wie oben definiert, bilden, oder $R^3$ zusätzlich ein Chloratom oder eine Cyanidgruppe sein kann.

Ganz besonders bevorzugte Zusammensetzgungen enthalten ein Titanocen der Formel I, worin $R^1$ und $R^2$ unabhängig voneinander Cyclopentadienyl oder Methylcyclopentadienyl bedeuten und $R^3$ und $R^4$ unabhängig voneinander einen Rest der Formel VII darstellen

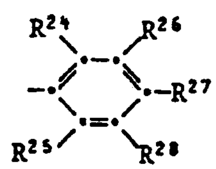
(VII),

worin $R^{24}$ und $R^{25}$ unabhängig voneinander ein Fluoratom oder eine —$CF_3$ Gruppe sind und $R^{26}$, $R^{27}$ und $R^{28}$ unabhängig voneinander Wasserstoff, ein Fluoratom oder eine —$CF^3$ Gruppe bedeuten.

Bevorzugte Zusammensetzungen enthalten 3-Ketocoumarine der Formel II, worin die Gruppen $R^{10}$, $R^{12}$ und $R^{13}$ Wasserstoff sind, $R^{11}$ Wasserstoff, —$NR^{15}R^{16}$ oder —$OR^{15}$ bedeutet, $R^{14}$ Wasserstoff oder Methyl ist und $R^5$ $C_1$-$C_{12}$Alkyl, Cyclohexyl, Phenyl, Tolyl oder Benzyl ist.

Ganz besonders bevorzugte Zusammensetzungen enthalten 3-Ketocoumarine der Formel II, worin die Gruppen $R^{10}$, $R^{12}$, $R^{13}$ und $R^{14}$ Wasserstoff sind, $R^{11}$ —$NR^{15}R^{16}$, bevorzugt —$N(C_1$-$C_6$-$Alkyl)_2$, insbesondere —$N(C_2H_5)_2$, bedeutet und $R^5$ ein Rest der Formel V oder Phenyl ist.

Mit den Titanocen-/3-Ketocoumaringemischen lassen sich ethylenisch ungesättigte Monomere oder Präpolymere photopolymerisieren. Beispiele für photopolymerisierbare Monomer- oder Präpolymerbausteine sind in den oben erwähnten EP-A betreffend Titanoceninitiatoren gegeben.

In einer besonderen Vorzugsform dieser Erfindung setzt man die Photoinitiatormischungen bei der Polymerisation von polymeren Vorstufen thermostabiler Polymerer ein.

Die Erfindung betrifft daher insbesondere Zusammensetzungen enthaltend

a) ein Titanocen der Formel I, wie oben definiert,

b) ein 3-Ketocoumarin der Formel II, wie oben definiert und

c) eine Polymer-Vorstufe mit gleichen oder verschiedenen wiederkehrenden Struktureinheiten der Formel VIII

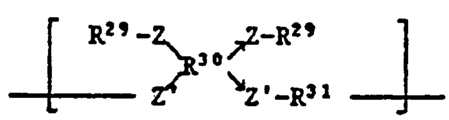
(VIII),

die beim Erwärmen zu einer thermostabilen Ringstruktur reagiert, worin

$R^{29}$ ein Rest mit einer photopolymerisierbaren olefinischen Doppelbindung ist,

$R^{30}$ ein vierwertiger aromatischer Rest nach dem Entfernen der vier funktionellen Gruppen ist, wobei je zwei funktionelle Gruppen benachbart sind und die Pfeile für Strukturisomerie stehen,

$R^{31}$ einen zweiwertigen aliphatischen, cycloaliphatischen oder ein-oder mehrkernig-aromatischen Rest bedeutet, wobei aromatische Reste $R^{31}$ in Orthostellung zur Bindung Z′ eine der Gruppen —$CONH_2$ oder —COOH aufweisen können,

die Z ein kovalentes oder ionisches Bindungsglied und die Z′ ein kovalentes Bindungsglied bedeuten, mit der Massgabe, dass Z und Z′ beim Erwärmen der photopolymerisierbaren Zusammensetzung unter Abspaltung von $R^{29}$, gegebenenfalls zusammen mit in $R^{31}$ enthaltenen Gruppen —$CONH_2$ oder —COOH, eine thermostabile Ringstruktur ergeben.

In den Polymer-vorstufen (c) können die $R^{29}$, $R^{30}$, $R^{31}$, Z und Z′ in den einzelnen Strukturelementen gleiche oder verschiedene Bedeutungen haben. Bei Copolymeren können die einzelnen Strukturelemente statistisch angeordnet sein, oder es kann sich um Blockcopolymere handeln, die nach an sich bekannten Methoden durch Verknüpfung verschiedener Blöcke hergestellt werden können. Wenn Z ein ionisches Bindungsglied darstellt, können auch aus Strukturelementen der Formel VIII erhaltene cyclisierte Derivate mit Polymer-Vorstufen mit wiederkehrenden Strukturelementen verknüpft werden.

Das mittlere Molekulargewicht ($\overline{M}_w$) der Polymer-Vorstufen beträgt vorzugsweise 5000 bis 100'000, besonders 5000 bis 50'000 und ganz besonders 10'000 bis 30'000. Die mittleren Molekulargewichte können z.B. durch Aufnahme von Gelpermeations-Chromatogrammen mit Polystyrol-Eichung bestimmt und verglichen werden.

Aromatische Reste $R^{30}$ können ein- oder mehrkernig und gegebenenfalls auch substituiert sein, z.B. durch Halogenatome, Alkyl- oder Alkoxygruppen mit je 1-4 C-Atomen. $R^{30}$ stellt z.B. einen Naphthalin- Phenanthren- oder Perylenrest und insbesondere einen Rest der Formel IX oder X dar

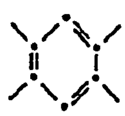 (IX), 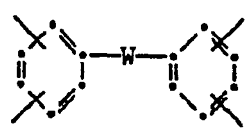 (X),

worin W eine direkte Bindung, —O—, —CO—, —$CH_2$—, —$C(CF_3)_2$—, —S—, —$SO_2$—, —NH— oder Alkyliden mit 2-12 C-Atomen bedeutet. Besonders bevorzugt stellt $R^{30}$ den Rest des Pyromellitsäuredianhydrids, eines Benzophenontetracarbonsäuredianhydrids oder eines Gemisches davon dar.

$R^{31}$ in der Bedeutung eines aliphatischen Restes enthält bevorzugt 2-20 C-Atome und kann z.B. lineares oder verzweigtes Alkylen sein, das durch Silan- oder Siloxangruppen unterbrochen sein kann. In der Bedeutung als cycloaliphatischer Rest enthält $R^{31}$ bevorzugt 5-7 Ringkohlenstoffatome und ist insbesondere Cyclohexylen, Cyclopentylen oder der Rest des Isophorondiamins. $R^{31}$ ist vorzugsweise ein aromatischer Rest mit insbesondere 6-16 C-Atomen, der auch substituiert sein kann, z.B. durch Halogenatome, OH, —COOH, —$CONH_2$, Alkyl- oder Alkoxygruppen mit 1-4 C-Atomen.

Besonders bevorzugt stellt $R^{31}$ einen Rest der Formeln XI, XII oder XIII dar

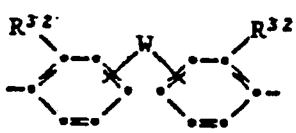 (XI), 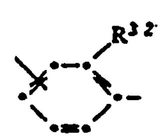 (XII),

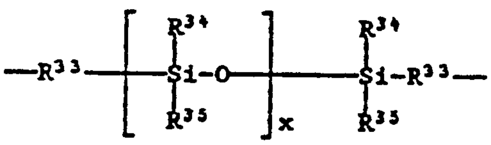 (XIII), wobei

W die oben angegebene Bedeutung hat und insbesondere —O—, —$CH_2$— oder —$C(CF_3)_2$— darstellt,

x eine ganze Zahl von 1-10, besonders 1-5 und vor allem 1, die $R^{32}$ unabhängig voneinander ein Wasserstoffatom, —$CONH_2$ oder —COOH,

$R^{33}$ —$C_pH_{2p}$— mit p = 1-5 und

$R^{34}$ und $R^{35}$ unabhängig voneinander geradkettiges oder verzweigtes Alkyl mit 1-6 C-Atomen, besonders Methyl, darstellen. Als Reste der Formeln XI und XII werden in para-Stellung bzw. 4,4'-Stellung gebundene Reste bevorzugt.

Die Gruppe $R^{29}$ weist bevorzugt die Formel XIV auf

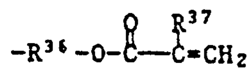 (XIV),

worin $R^{36}$ $-C_mH_{2m}-$ mit m = 2-12, wie Ethylen, 1,2- oder 1,3-Propylen, 1,2-, 1,3- oder 1,4-Butylen, n-Pentylen, n-Hexylen, n-Octylen oder n-Dodecylen, $-CH_2CH(OH)CH_2-$ oder Polyoxaalkylen mit 4-30 C-Atomen, wie die Reste von Diethylenglykol, Triethylenglykol, Tetraethylenglykol, Polyethylenglykol, Dipropylenglykol oder Polypropylenglykol bedeutet, und $R^{37}$ ein Wasserstoffatom oder Methyl ist.

Bei Z = $-COO-$ kann $R^{29}$ auch $-CH{=}CH_2$, $-CH_2CH{=}CH_2$ oder $-CH_2C(CH_3){=}CH_2$ sein.

$R^{36}$ ist bevorzugt Ethylen, 1,2- oder 1,3-Propylen oder $-CH_2CH(OH)CH_2-$ und $R^{37}$ ist insbesondere Methyl.

Bevorzugt sind Polymer-Vorstufen (c), worin $R^{31}$ in 0-100 % der wiederkehrenden Strukturelemente einen Rest der Formel XI und in 100-0% der wiederkehrenden Strukturelemente einen Rest der Formel XII darstellt, sowie Polymer-Vorstufen, worin $R^{31}$ in 70-100% der wiederkehrenden Strukturelemente einen Rest der Formel XI und/oder XII und in 30-0% der wiederkehrenden Strukturelemente einen Rest der Formel XIII bedeutet.

Z kann definitionsgemäss eine kovalente oder ionische Bindung darstellen. Als ionische Bindungen kommen vor allem solche zwischen Carboxylgruppen und tertiären Aminen in Betracht. Z ist vorzugsweise $-COO-$, $-CONH-$, $-O-$, $-NH-$, $-COOH/NR^{38}R^{39}-$ oder

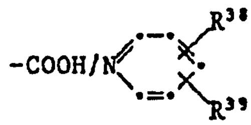 ,

worin $R^{38}$ und $R^{39}$ unabhängig voneinander Alkyl oder Alkenyl mit bis zu 6 C-Atomen, besonders je Methyl, darstellen.

Z' bedeutet bevorzugt $-CONH-$, $-NHCO-$, $-NH-CO-NH-$ oder $-O-CO-NH-$.

Besonders bevorzugt ist Z $-CONH-$, $-COO-$ oder $-COOH/N(CH_3)_2-$ und Z' stellt $-CONH-$ dar, oder Z ist $-O-$, und Z' bedeutet $-NHCO-$.

Die Gruppen Z und Z' müssen definitionsgemäss beim Erwärmen unter Abspaltung der Gruppen $R^{28}$, gegebenenfalls zusammen mit in $R^{31}$ enthaltenen Gruppen $-CONH_2$ oder $-COOH$, thermostabile Ringstrukturen ergeben. Dabei kann es sich je nach Art der Gruppen Z und Z' bzw. um folgende Ringstrukturen handeln

($R^{30}$ = 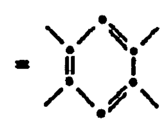

und $R^{31}$ = aromatischer Rest, Ar, der auch Bestandteil der Ringstruktur sein kann) :

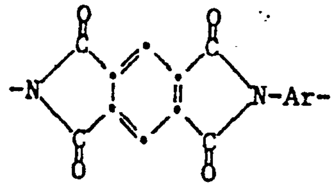

[A, Polyimide],

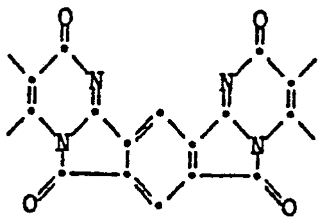

[B, Poly(isoindolochinazolidindione)],

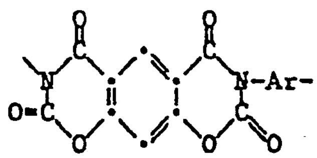

[C, Poly(oxazindione)],

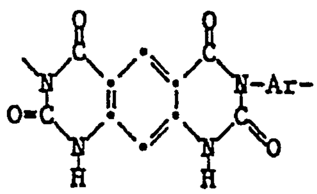

[D, Poly(chinazolindione)],

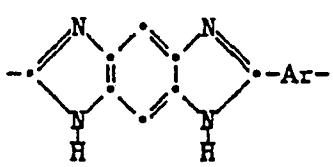

[E, Poly(imidazole)],

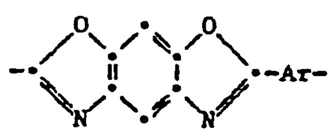

[F, Poly(oxazole)] und

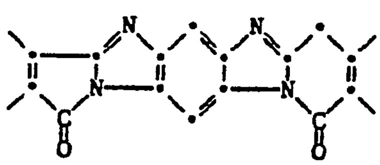

[G, Poly(imidazopyrrolone)].

Die Herstellung dieser Ringstrukturen und der entsprechenden Präpolymere kann z.B. wie in der EP-A 119162 beschrieben erfolgen.

Besonders bevorzugt sind Polymer-Vorstufen mit wiederkehrenden Strukturelementen der Formel VIIIa

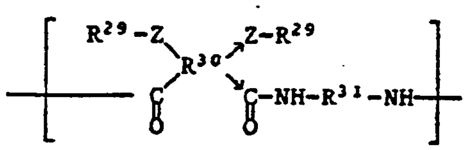

(VIIIa),

worin $R^{30}$ der vierwertige Rest einer aromatischen Tetracarbonsäure nach Entfernen von vier Carboxylgruppen ist und $R^{31}$, $R^{29}$ und Z die unter Formel VIII angegebenen Bedeutung haben. Z stellt dabei vorzugsweise —CO-O— dar.

Des weiteren sind Polymer-Vorstufen mit wiederkehrenden Strukturelementen der Formel VIIIb bevorzugt,

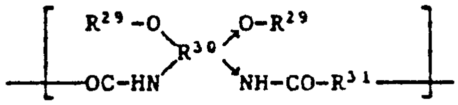

(VIIIb),

worin $R^{30}$ der Rest des 3,3'-Dihydroxybenzidins ist, die $R^{31}$ in den einzelnen wiederkehrenden Strukturelementen unabhängig voneinander den Rest der Isophthalsäure oder der 4,4'-Benzophenondicarbonsäure darstellen und $R^{29}$ die unter Formel VIII angegebene Bedeutung hat.

Die durch → angedeutete Strukturisomerie kann z.B. mit Pyromellitsäure folgendermassen dargestellt werden (Z = —CO-O—) :

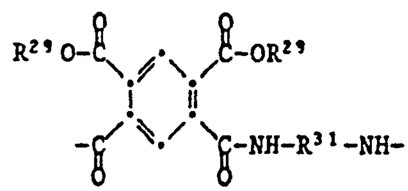

oder

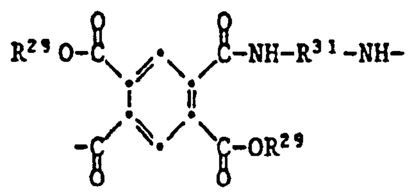

Die Polymer-Vorstufen (c) sind bekannt oder können nach an sich bekannten Methoden hergestellt werden (vgl. z.B. das Reaktionsschema in der EP-A 119162 und die US Patentschriften 4,329,419 und 4,030,948).

Geeignete Verbindungen zur Herstellung der Polymer-Vorstufen (c) sind z.B. in der EP-A 119162 genannt und sind ebenfalls Gegenstand der vorliegenden Beschreibung.

Besonders bevorzugt sind Zusammensetzungen, worin die Polymer-Vorstufe (c) aus wiederkehrenden Strukturelementen der Formel VIIIc besteht

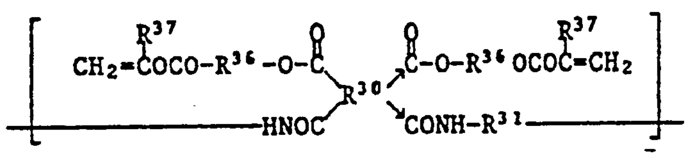

(VIIIc),

worin $R^{30}$ den Rest des Pyromellitsäuredianhydrids, eines Benzophenontetracarbonsäuredianhydrids oder ein Gemisch solcher Reste darstellt, die $R^{31}$ in den einzelnen wiederkehrenden Strukturelementen unabhängig voneinander 1,3- oder 1,4-Phenylen, den Rest 4,4'-Diaminodiphenylethers, 4,4'-Diaminodiphenylmethans, 2,2-Bis-(4-aminophenyl)-hexafluoropropans, 4,4'-Diamino-3-carbonamidodiphenylethers oder 4,4'-Diamino-3,3'-bis-carbonamidobiphenyls darstellen, $R^{36}$ $-CH_2CH_2-$ oder $-CH_2CH(OH)CH_2-$ und $R^{37}$ ein Wasserstoffatom oder Methyl bedeuten, sowie Zusammensetzungen, worin die Polymer-Vorstufe (c) aus wiederkehrenden Strukturelementen der Formel VIIId besteht

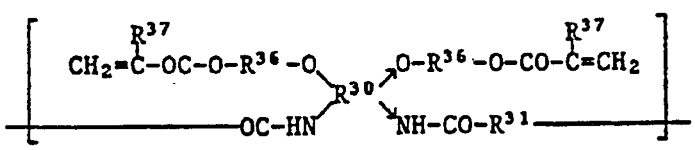

(VIIId),

worin $R^{30}$ den Rest des 3,3'-Dihydroxybenzidins, die $R^{31}$ in den einzelnen wiederkehrenden Strukturelementen

unabhängig voneinander 1,3-Phenylen oder den Rest der 4,4'-Benzophenondicarbonsäure, $R^{36}$ $-CH_2CH_2-$, $-CH_2CH_2CH_2-$ oder $-CH_2-CH(OH)-CH_2-$ und $R^{37}$ ein Wasserstoffatom oder Methyl darstellen.

Im speziellen seien Polymer-Vorstufen mit wiederkehrenden Strukturelementen der Formeln VIIIe bis VIIIk erwähnt:

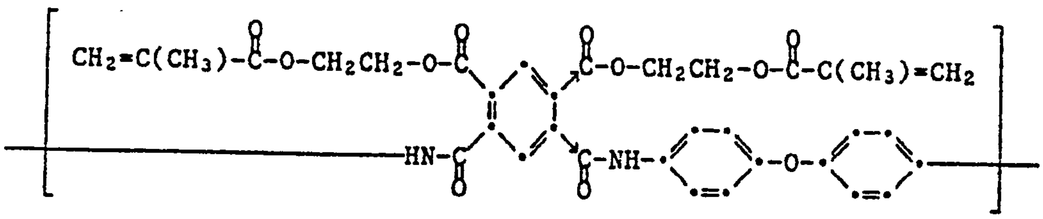

(VIIIe),

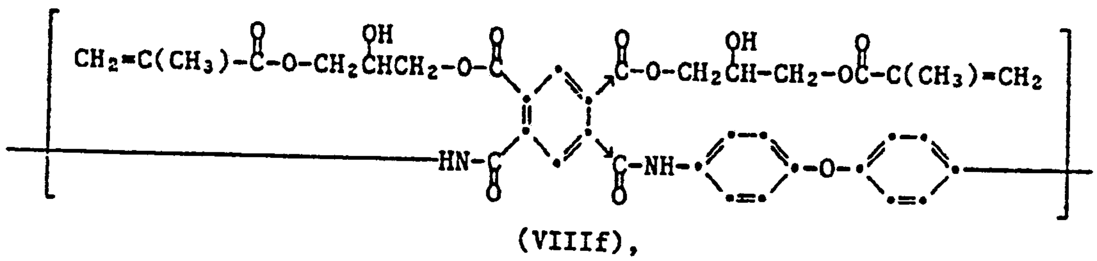

(VIIIf),

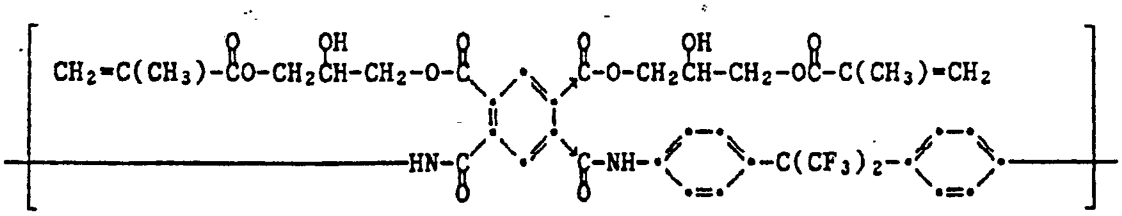

(VIIIg),

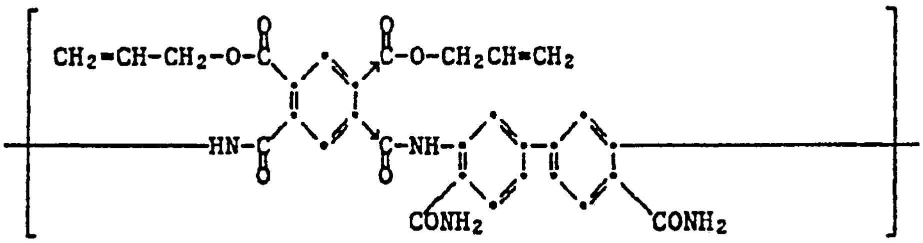

(VIIIh)

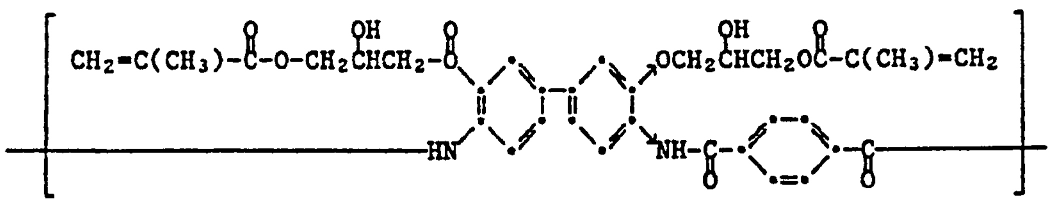

(VIIIi),

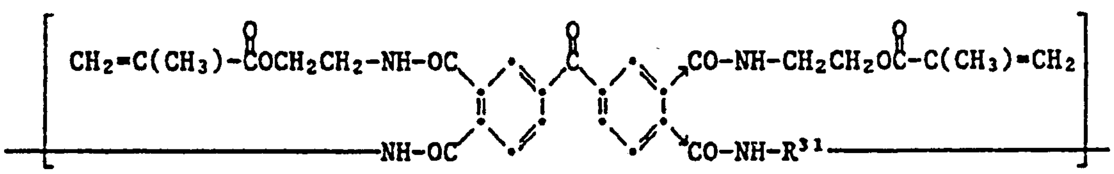

(VIIIk),

worin $R^{31}$ in 70 % der Strukturelemente 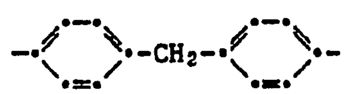 und in

30 % der Strukturelemente $-(CH_2)_3-Si(CH_3)_2-O-Si(CH_3)_2-(CH_2)_3-$ ist.

Die erfindungsgemässen photopolymerisierbaren Zusammensetzungen enthalten vorzugsweise noch eine ausgewählte niedermolekulare Cokomponente d).

Die Erfindung betrifft daher bevorzugt Zusammensetzungen enthaltend die Komponenten a), b) und c), wie oben definiert und zusätzlich d) einen Acrylsäureester, methacrylsäureester, Allylether oder Allylester oder Teilester dieser Säuren mit einem Polyol.

Die Mitverwendung diese Komponente d) führt in der Regel zu einer wesentlichen Erhöhung der Lichtempfindlichkeit der photopolymerisierbaren Zusammensetzung und somit zu einer Verkürzung der erforderlichen

Belichtungszeit.

Als Komponente d) kommen z.B. definitionsgemässe Ether und vor allem Ester und Teilester von (Meth)acrylsäure und aromatischen und besonders aliphatischen Polyolen mit insbesondere 2-30 C-Atomen oder cycloaliphatischen Polyolen mit bevorzugt 5 oder 6 Ringkohlenstoffatomen in Betracht. Diese Polyole können auch mit Epoxiden, wie Ethylenoxid oder Propylenoxid, modifiziert sein. Ferner sind auch die Teilester und Ester von Polyoxaalkylenglykolen geeignet. Beispiele für Komponenten d) sind die folgenden : Ethylenglykoldimethacrylat, Diethylenglykoldimethacrylat, Triethylenglykoldimethacrylat, Tetraethylenglykoldimethacrylat, Polyethylenglykoldimethacrylate mit einem mittleren Molekulargewicht im Bereich von 200-2000, Ethylenglykoldiacrylat, Diethylenglykoldiacrylat, Triethylenglykoldiacrylat, Tetraethylenglykoldiacrylat, Polyethylenglykoldiacrylate mit einem mittleren Molekulargewicht im Bereich von 200-2000, Trimethylolpropanethoxylattrimethacrylat, Trimethylolpropanpolyethoxylattrimethacrylate mit einem mittleren Molekulargewicht im Bereich von 500-1500, Trimethylolpropanethoxylattriacrylate mit einem mittleren Molekulargewicht von 500-1500, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, 1,3-Butandioldimethacrylat, Sorbittriacrylat, Sorbittetraacrylat, Sorbittetramethacrylat, Sorbitpentaacrylat, Sorbithexaacrylat, Oligoesteracrylate, Oligoestermethacrylate, Glyzerindi- und -triacrylat, 1,4-Cyclohexandiacrylat, Bisacrylate und Bismethacrylate von Polyethylenglykolen mit einem mittleren Molekulargewicht von 100-1500, Ethylenglykoldiallylether, Bernsteinsäure- und Adipinsäurediallylester oder Gemische der genannten Verbindungen.

Der Titanoceninitiator a) und das 3-Ketocoumarin b) werden in der Regel in Mengen von 10 : 1 bis 0,5 : 1 Gew.-Teilen eingesetzt. Vorzugsweise beträgt das Gewichtsverhältnis von Komponente a) zu Komponente b) 5 : 1 bis 1 : 1 und ganz besonders bevorzugt 4 : 1 bis 2 : 1. Die photopolymerisierbare Zusammensetzung enthält in der Regel 0,1-10 Gew.-% Komponente a), 0,01-5 Gew.% Komponente b) und 99,89-85,0 Gew.% Komponente c) und gegebenenfalls d) ; dabei beziehen sich die Prozentangaben auf die Menge aus a), b), c) und gegebenenfalls d).

Vorzugsweise enthält die photopolymerisierbare Zusammensetzung 0,2-5,0 Gew.% Komponente a), 0,1-3,0 Gew.% Komponente b) und 99,7-92,0 Gew.% Komponente c), und gegebenenfalls d).

die Mengenverhältnisse von photopolymerisierbarer Präpolymerenkomponente c) und niedermolekularem Comonomerbaustein d) betragen vorzugsweise 10 : 1 bis 1 : 1, ganz besonders bevorzugt 5 : 1 bis 1 : 1 Gewichtsteile.

Die erfindungsgemässe photopolymerisierbare Zusammensetzung kann weitere übliche Zuschlagstoffe enthalten, z.B. Stabilisatoren, insbesondere Inhibitoren für die thermische Polymerisation, wie Thiodiphenylamin und Alkylphenole, z.B. 4-Tertiärbutylphenol, 2,5-Ditertiärbutylhydrochinon oder 2,6-Di-tert.-butyl-4-methylphenol.

Weiter kann die Zusammensetzung zusätzliche Initiatoren und Sensibilisatoren enthalten, beispielsweise aromatische Ketone, wie Tetramethyldiaminobenzophenon, Benzophenon, Michler's Keton [4,4′-Bis(dimethylamino)benzophenon], 4,4′-Bis(diethylamino)benzophenon, 4-Acryloxy-4′-diethylaminobenzophenon, 4-Methoxy-4′-dimethylaminobenzophenon, 2-Ethylanthrachinon, Phenanthrachinon, 2-t-Butylanthrachinon, 1,2-Benzanthrachinon, 2,3-Benzanthrachinon, 2,3-Dichlornaphthochinon, Benzyldimethylketal und andere aromatische Ketone, z.B. gemäss US-Patent 3.552.973 ; Benzoin, Benzoinether, wie Benzoinmethylether, Benzoinethylether, Benzoinisobutylether und Benzoinphenylether, Methylbenzoin, Ethylbenzoin und andere Benzoine ; p-Maleinimidobenzolsulfonsäureazid, Thioxanthonderivate, wie Thioxanthon, 2-Chlorthioxanthon, 2-Isopropylthioxanthon, Thioxanthon-1-carbonsäureethylester, 3-Methoxythioxanthon-1-carbonsäureethylester in Verbindung mit aromatischen Aminen, wie p-Dimethylaminobenzoesäureethylester und 4,4′-Bis(dimethylamino)benzophenon ; Bisazide wie 2,6-(4′-Axidobenzyliden)-4-methylcyclohexan-1-on.

Weitere Zusätze sind Lösungsmittel, die allein oder in Kombinationen verwendet werden können, wie N-Methylpyrrolidon, Butyrolacton, Ethylenglykol-monoethylether, Dimethylformamid, Dimethylacetamid und Hexamethylphosphorsäuretriamid ; Pigmente, Farbstoffe, Füllstoffe, Haftmittel, Netzmittel und Weichmacher, sowie Farbstoffe, die durch ihre Eigenabsorption die spektrale Empfindlichkeit der Mischungen beeinflussen können.

Die Herstellung der erfindungsgemässen Zusammensetzungen erfolgt durch Vermischen der Komponenten in hierfür üblichen Einrichtungen.

Die erfindungsgemässe photopolymerisierbaren Zusammensetzungen eignen sich hervorragend als Beschichtungsmittel für Substrate aller Art, z.B. Keramik, Metalle, wie Kupfer und Aluminium, Halbmetalle und Halbleitermaterialien, wie Silicium, Geranium und GaAs, sowie Isolatorschichten, wie $SiO_2$ und $Si_3N_4$-Schichten, bei denen durch Photopolymerisation eine Schutzschicht oder eine photographische Abbildung aufgebracht werden soll.

Die Herstellung der beschichteten Substrate kann z.B. erfolgen, indem man eine Lösung oder Suspension der Zusammensetzung herstellt. Die Wahl des Lösungsmittels und die Konzentration richtet sich sich hauptsächlich nach der Art der Zusammensetzung und nach dem Beschichtungsverfahren. Die Lösung wird mittels bekannten Beschichtungsverfahren gleichförmig auf ein Substrat aufgebracht, z.B. durch Aufschleudern, Tauchen, Rakelbeschichtung, Vorhanggiessverfahren, Aufpinseln, Sprühen und Reverse-roll-Beschichtung.

Die Photopolymerisation von (Meth)acrylaten und ähnlichen olefinischen ungesättigten Verbindung wird bekanntlich durch Luftsauerstoff gehemmt, besonders in dünnen Schichten. Dieser Effekt lässt sich mit bekannten üblichen Methoden, wie z.B. Aufbringen einer temporären Deckschicht aus Polyvinylalkohol oder durch Vorbelichten oder Vorkonditionieren unter Inertgas, vermindern.

Nach dem Beschichten wird das Lösungsmittel durch Trocknen entfernt und es resultiert eine Schicht des lichtempfindlichen Polymeren auf dem Träger. Die Schichtdicken betragen zweckmässig etwa 0,05 bis 200 µm, vorzugsweise 1,0-50 µm. Nach der in üblicher Weise erfolgten bildmässigen Belichtung des Materials durch eine Photomaske werden die unbelichteten Stellen des Polymers durch Herauslösung in einem Entwickler (Lösungsmittel) entfernt und das Polymerrelief, bestehend aus vernetztem erfindungsgemässem Polymer, freigelegt. Geeignete Entwickler sind z.B. Lösungsmittel oder Gemische von Lösungsmittel wie N-Methylpyrrolidon, N-Acetylpyrrolidon, 4-Butyrolacton, Aethylentglykolmonomethyläther, Dimethylformamid, Dimethylacetamid, Dimethylsulfoxid und Cyclohexanon mit Nichtlösungsmitteln, wie Toluol, Xylol, Aethanol, Methanol oder Aceton.

Die Belichtung der erfindungsgemässen Zusammensetzungen kann durch eine grosse Anzahl der verschiedensten Lichtquellen erfolgen. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen. Insbesondere eignen sich Lampen, die im Spektralbereich von 400-480 nm eine vergleichsweise hohe Strahlungsintensität besitzen. Der Abstand zwischen Lampe und erfindungsgemässem Bildmaterial kann je nach Anwendungszweck und Lampentyp bzw. -stärke variieren, z.B. zwischen 2 cm bis 150 cm.

Durch die Zugabe von 3-Ketocoumarinen lassen sich die photopolymerisierbaren Zusammensetzungen dieser Erfindung optisch abstimmen, d.h. man kann über die Menge des Coinitiators die Lichtmenge bestimmen, die bei vorgegebener Lichtleistung in eine bestimmte Schichttiefe vordringen soll. Durch das 3-Ketocoumarin wird die Photoempfindlichkeit des Titanoceninitiators nicht herabgesetzt. Mit den erfindungsgemässen Zusammensetzungen lassen sich, insbesondere auf stark reflektierenden oder stark streuenden Substraten, Abbildungen hoher Auflösung herstellen.

Unter einem Substrate mit einer stark reflektierenden oder stark streuenden Oberfläche versteht man im allgemeinen ein Substrat, das wenigstens 20 % der auf die Oberfläche auftreffenden Lichtenergie reflektiert bzw. zurückstreut.

Die Erfindung betrifft auch eine Verfahren zur Herstellung von Abbildungen oder Schutzschichten umfassend die Schritte

i) Aufbringen einer Zusammensetzung enthaltend Komponenten a), b), c) und gegebenenfalls d), wie oben definiert, auf ein Substrat, vorzugsweise auf ein Substrat mit einer stark streuenden oder reflektierenden Oberfläche,

ii) bildmässige Belichtung des Systems,

iii) gegebenenfalls thermische Vorbehandlung, um die belichteten Stellen vorzuhärten,

iv) Entwickeln des Systems und

v) thermische Cylisierung der Komponente c).

Die Erfindung betrifft ferner die durch das obige Verfahren erhältlichen Abbildungen oder Schutzschichten.

Ganz besonders betrifft die Erfindung die Verwendung der photopolymerisierbaren Zusammensetzungen enthaltend die Komponenten a), b), c) und gegebenenfalls d) in Abbildungsverfahren auf stark streuenden oder stark reflektierenden Substraten.

Die wichtigsten Anwendungen sind die Verwendung als Aetzresist, Galvanoresist und Lötstopplack bei der Herstellung von gedruckten Schaltungen und Druckplatten, die Herstellung von Photopolymerdruckplatten für den Offsetdruck, Buchdruck (Hochdruck), sowie beim Flexodruck und Siebdruck als Abdecklack und zur Herstellung von photographischen Bildaufzeichnungsmaterialien, z.B. gemäss DE-A-2651864 oder DE-A-2202360.

Hauptanwendung ist die Herstellung von hitze- und chemikalienbeständigen Reliefstrukturen von z.B. etwa 0,05 bis 200 µm Schichtstärke auf elektronischen Bauteilen, wie Kondensatoren, diskreten Halbleitern, integrierten Schaltkreisen, Hybridschaltungen, Leiterplatten, Flüssigkristallanzeigen und Photosensoren. Insbesondere eignen sich die Zusammensetzungen für den Einsatz auf aktiven Bauelementen, so als

Passivierschutz, besonders als α-Strahlenschutz für Speicherbausteine (relativ dicke Schichten) oder als Dielektrikum für Mehrlagen-Schaltungen (dünnere Schichten).

Für diese Anwendung werden die beschichteten und gegebenenfalls bildmässig belichteten und entwickelten Materialien zu bei hohen Temperaturen beständigen Abbildungen getempert, vorzugsweise bei Temperaturen zwischen 300 und 400°C, wobei die Umwandlung in Ringstrukturen erfolgt und flüchtige Anteile entfernt werden.

Beispiel 1 :

Mit einem Polyamidsäureester entsprechend EP-A 119,162, Beispiel 7 wird nach folgender Formel eine Photoempfindliche Lösung hergestellt :

| | | |
|---|---|---|
| N-Methylpyrrolidon (NMP) | | 10,83 g |
| Di-π-methylcyclopentadienyl-Ti-bis-2,6-Difluorophen-1-yl | | 0,40 g |
| 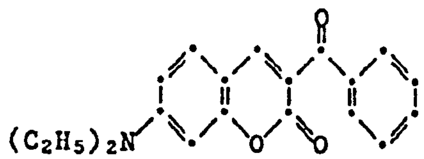 | Verb. I | 0,10 g |
| Tetraethylenglykoldimethacrylat | | 1,50 g |
| Polyamidsäureester ($\bar{M}_w$ = 10'500) | | 10,00 g |

Die Lösung wird auf 0,8 µm filtriert und dann bei 2800 U/min 15 s lang auf weisse Keramikblättchen der Grösse 63 x 63 mm aufgeschleudert, die zuvor mit dem Haftvermittler γ-Aminopropyltriethoxysilan behandelt worden sind. Man trocknet 1 Stunde lang bei 70°C und belichtet dann mittels einer Masken-Justier- und Belichtungsmaschine im Vakuumkontakt, wobei das USAF 1951 Testmuster der Firma Itek verwendet wird. Man belichtet mit einer Lichtenergie von 110 mJ/cm$^2$ (bezogen auf die Lichtsonde von 400 nm der Firma Optical Associates Inc.) und entwickelt dann 45 s lang durch Aufsprühen einer Mischung aus 4-Butyrolacton und Xylol (1 : 1). Man erhält hochaufgelöste Reliefstrukturen der Schichtstärke 18,5 µm, wobei auch noch das Bildelement 4,6 (17,5 µm breite Gräben) noch dergestalt aufgelöst ist, dass die darunterliegende poröse Keramikoberfläche freigelegt ist.

Belichtet man durch das entsprechende USAF 1951 Testmuster, das freistehende Stege erzeugt, mit einer Belichtungsenergie von 154 mJ/cm$^2$, so erhält man nach einer Entwicklungszeit von 30 s hoch aufgelöste Reliefstrukturen der Schichtstärke 18, 5 µm, die im Rasterelektronenmikroskop ein deutlich definiertes nach unten verjüngtes konisches Profil (d.h. einen negativen Kantenwinkel) zeigen.

Beispiel 2 :

Mit einem Polyamidsäureester entsprechend EP-A 119,162, Beispiel 7 wird nach folgender Formel eine photoempfindliche Lösung hergestellt :

| | |
|---|---|
| N-Methylpyrrolidon (NMP) | 41,79 g |
| Di-π-methylcyclopentadienyl-Ti-bis-Pentafluorophenyl | 1,40 g |
| 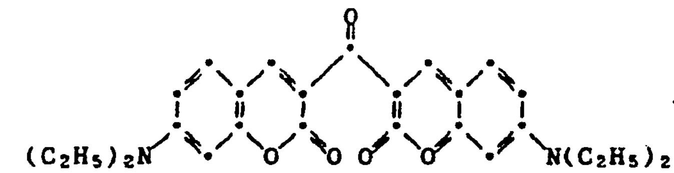 Verb. II | 0,32 g |
| Tetraethylenglykoldimethacrylat | 15,00 g |
| Polyamidsäureester ($\bar{M}_w$ = 10'500) | 40,00 g |

Die Lösung wird auf 0,65 µm filtriert und dann bei 1400 U/min 20 s lang auf weisse Keramikblättchen der Grösse 63 × 63 mm aufgeschleudert, die zuvor mit dem Haftvermittler γ-Aminopropyltriethoxysilan behandelt worden sind. Man trocknet 35 min lang bei 80°C und belichtet dann mittels einer Masken-Justier- und Belichtungsmaschine im Vakuumkontakt, wobei das USAF 1951 Testmuster der Firma Itek verwendet wird. Man belichtet mit einer Lichtenergie von 75 mJ/cm² (bezogen auf die Lichtsonde von 400 nm der Firma Optical Associates Inc.) und entwickelt dann in einem Sprühentwickler 35 s lang durch Aufsprühen einer Mischung aus 4-Butyrolacton und Xylol (1 : 1, Volumen), wobei man eine Feinnebeldüse Verwendet, gefolgt von einem Spülzyklus mit Xylol von 5 s Man erhält Reliefstrukturen der Schichtstärke 32 µm, wobei auch noch das Bildelement 3,1 (62,5 µm breite Gräben) noch dergestalt aufgelöst ist, dass die darunterliegende poröse Keramikoberfläche freigelegt ist.

Beispiel 3 :

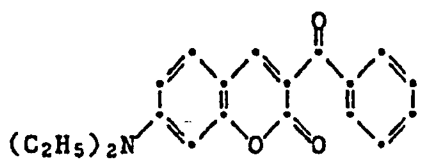

Verb. I

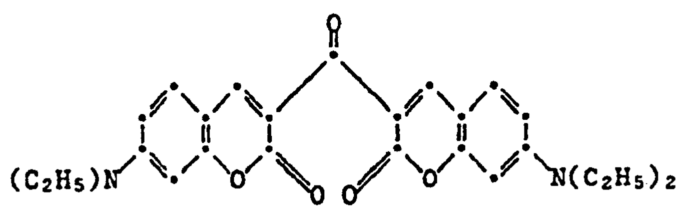

Verb. II

| | |
|---|---|
| Aus jeweils | |
| N-Methylpyrrolidon (NMP) | 13,588 g |
| Di-π-methylcyclopentadienyl-Ti-bis-2,6-Difluorophen-1-yl | 0,245 g |
| Tetraethylenglykoldimethacrylat | 1,05 g |
| Polyamidsäureester ($\bar{M}_w$ = 10'500; Beispiel 7 der EP-A 119,162) | 7,00 g |

werden durch verschiedene Zusätze der Verbindung I und II photoempfindliche Lösungen hergestellt und die daraus hergestellten Beschichtungen werden bezüglich ihrer Photoempfindlichkeit in folgender Weise verglichen :

Die gefilterten Lösungen werden jeweils bei 5'100 U/min 25 s lang auf mit γ-Aminopropyltriethoxysilan vorbehandelte Siliziumwafer aufgeschleudert, wobei nach der Trocknung (80°C, 30 min) jeweil 2 µm starke Beschichtungen gewonnen werden. Man belichtet mit einer Maskenjustier- und Belichtungsmaschine, wobei gleichzeitig sowohl eine Testmaske mit Feinstrukturen als auch eine Maske mit Graukeilstufen verwendet wird. Nach dem Entwickeln durch Aufsprühen einer Mischung aus 4-Butyrolacton und Xylol (1 : 2, Vol.) zeigen sich in Abhängigkeit der zugegebenen Mengen der Verbindungen I und II folgende relative Empfindlichkeiten :

| Menge des Zusatzes [%] bezügl. Polyamids.ester | | Relative Empfindlichkeit |
|---|---|---|
| Verb. I | Verb. II | |
| - | - | 100 % |
| 1.0 | - | 304 % |
| 2.0 | - | 388 % |
| - | 1.0 | 210 % |
| - | 2.0 | 278 % |

Beispiel 4 :

Eine Lösung bestehend aus

| | |
|---|---|
| Methoxypropylacetat | 10,441 g |
| Copolymer aus Styrol und Maleinsäureanhydrid (Monsanto Scripset® 550) | 2,059 g |
| Trimethylolpropantriacrylat | 2,206 g |
| Polyethylenglykol-200-diacrylat | 0,294 g |
| Di-π-methylcyclopentadienyl-Ti-bis-2,6-difluorophen-1-yl | 0,114 g |
| 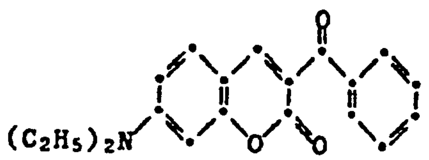 Verb. I | 0,055 g |

wird auf 0,45 µm filtriert und mit 900 U/min 10 s lang auf weisse Keramikblättchen der Grösse 63 × 63 mm aufgeschleudert, nachdem man die Blättchen mit dem Haftvermittler γ-Aminopropyltriethoxysilan vorbehandelt hat. Man trocknet 10 min lang bei 100°C auf einem "Hotplate" und schleudert dann mit 4000 U/min eine Lösung aus

| | |
|---|---|
| Polyvinylalkohol (Mowiol® 4-88, Hoechst) | 12,00 g |
| Triton® X-100 | 0,12 g |
| Deionisiertes Wasser | 88,00 g |

auf. Nach erneutem Trocknen bei 80°C (5 min) belichtet man mit 12,4 mJ/cm² durch ein USAF 1951 Testmuster, wäscht die Polyvinylalkoholschicht 2 min lang mit Wasser ab und entwickelt dann 30 s lang in einer Lösung zusammengesetzt aus

| | |
|---|---|
| $Na_2SiO_3 \cdot 5H_2O$ | 37,5 g |
| Antarox®-CO-630 | 1,0 g |
| Deionisiertes Wasser | 1000,0 g |

unter Zuhilfenahme von Ultraschall. Man erhält Reliefstrukturen der Schichtstärke 5 µm (freistehende Linien), wobei das Bildelement 3.3 (49,5 µm breite Linien) noch aufgelöst ist.

## Patentansprüche

1. Zusammensetzungen enthaltend

a) einen Titanocen-Photoinitiator der Formel I

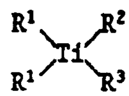

(I), und

b) ein 3-Ketocoumarin der Formel II

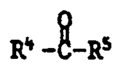

(II),

worin beide $R^1$ unabhängig voneinander unsubstituiertes oder durch $C_1$-$C_6$Alkyl oder $C_1$-$C_6$Alkoxy substituiertes Cyclopentadienyl$^{\ominus}$, Indenyl$^{\ominus}$, 4,5,6,7-Tetrahydroindenyl$^{\ominus}$ oder zusammen einen Reste der Formel III darstellen

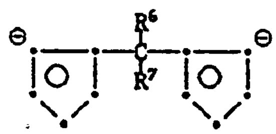

(III),

wobei $R^6$ und $R^7$ unabhängig voneinander Wasserstoff oder Methyl bedeuten, $R^2$ einen 6-gliedrigen carbocyclischen-aromatischen Ring oder einen 5- oder 6-gliedrigen heterocyclischen-aromatischen Ring bedeutet, der in mindestens einer der beiden Orthostellungen zur Metallkohlenstoffbindung durch eine Fluoratom oder durch eine Gruppe —$CF_2R$ substituiert ist, wobei R für ein Fluoratom oder für Methyl steht, $R^3$ eine der Bedeutungen von $R^2$ besitzt oder zusätzlich für Halogen, Pseudohalogen, —$OR^8$ oder —$SR^9$ steht, wobei $R^8$ Wasserstoff, $C_1$-$C_6$Alkyl, Phenyl, Acetyl oder Trifluoracetyl ist und $R^9$ $C_1$-$C_6$Alkyl oder Phenyl bedeutet, oder $R^2$ und $R^3$ zusammen einen Rest der Formel IV bilden

—Q-Y-Q— (IV),

worin Q für einen 6-gliedrigen carbocyclishen-aromatischen oder 5-oder 6-gliedrigen heterocyclishen-aromatischen Rest steht, wobei die beiden Bindungen jeweils in Orthostellung zur Brücke Y stehen und die Metastellung zur Brücke Y jeweils durch eine Fluoratom oder eine Gruppe —$CF_2R$ substituiert ist und Y eine direkte Bindung, —O—, —S—, —$SO_2$—, —CO—, —$CH_2$— oder —$C(CH_3)_2$— darstellt, $R^4$ ein Rest der Formel V ist

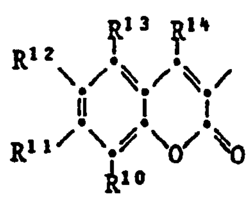

(V),

$R^5$ $C_1$-$C_{20}$Alkyl, Cycloalkyl mit 5-7 Ringkohlenstoffatomen, gegebenenfalls durch ein bis drei $C_1$-$C_6$Alkylgruppen, $C_1$-$C_6$Alkoxygruppen oder Halogenatome oder durch eine Diphenylamino- oder $C_1$-$C_6$Dialkylaminogruppe substituiertes Phenyl oder Naphthyl, $C_7$-$C_9$Aralkyl, ein Rest

$$-(CH{=}CH)_a-C_6H_5$$

oder eine Rest der Formel V ist, a 1 oder 2 bedeutet, $R^{10}$, $R^{11}$, $R^{12}$, $R^{13}$ und $R^{14}$ unabhängig voneinander Was-

serstoff, $C_1$-$C_6$Alkyl, $C_1$-$C_8$Alkoxy, Phenyl, Tolyl, Xylyl oder Benzyl sind, und $R^{11}$ zusätzlich noch eine Gruppe —$NR^{15}R^{16}$ oder —$OR^{15}$ sein kann, worin $R^{15}$ und $R^{16}$ unabhängig voneinander Wasserstoff oder $C_1$-$C_6$Alkyl sind und wobei ferner gilt, dass zwei oder drei der Reste $R^{10}$, $R^{11}$, $R^{12}$ und $R^{13}$ zusammen mit den Ringkohlenstoffatomen, an denen sie sitzen, einen ankondensierten Ring mit 5-oder 6-Ringatomen oder eine ankondensiertes Ringsystem mit 5- oder 6-gliedrigen Ringen bilden können.

2. Zusammensetzungen gemäss Anspruch 1, worin beide $R^1$ unabhängig voneinander unsubstituiertes oder mit ein oder zwei Methylgruppen substituiertes Cyclopentadienyl bedeuten, $R^2$ und $R^3$ unabhängig voneinander einen Rest der Formel VI darstellen

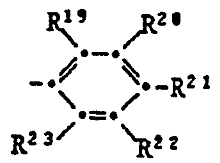
(VI),

worin $R^{19}$ ein Fluoratom oder eine Gruppe —$CF_2R$ ist, $R^{20}$, $R^{21}$, $R^{22}$ und $R^{23}$ unabhängig voneinander ein Fluoratom, eine Gruppe —$CF_2R$, Wasserstoff, $C_1$-$C_6$Alkyl oder $C_1$-$C_6$Alkoxy sind oder $R^2$ und $R^3$ zusammen eine Gruppe der Formel IVa bilden

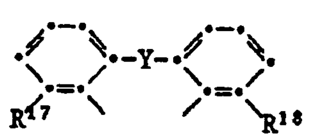
(IVa)

worin $R^{17}$ und $R^{18}$ unabhängig voneinander ein Fluoratom oder eine Gruppe —$CF_2R$ bedeuten und Y die in Anspruch 1 definierte Bedeutung besitzt, oder $R^3$ zusätzlich ein Chloratom oder eine Cyanidgruppe sein kann.

3. Zusammensetzungen gemäss Anspruch 1, worin $R^1$ und $R^2$ unabhängig voneinander Cyclopentadienyl oder Methylcyclopentadienyl bedeuten, und $R^3$ und $R^4$ unabhängig voneinander einen Rest der Formel VII darstellen

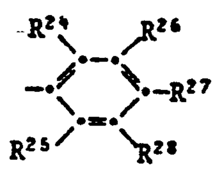
(VII),

worin $R^{24}$ und $R^{25}$ unabhängig voneinander ein Fluoratom oder eine —$CF_3$ Gruppe sind und $R^{26}$, $R^{27}$ und $R^{28}$ unabhängig voneinander Wasserstoff, ein Fluoratom oder eine —$CF_3$ Gruppe bedeuten.

4. Zusammensetzungen gemäss Anspruch 1, worin die Gruppen $R^{10}$, $R^{12}$ und $R^{13}$ Wasserstoff sind, $R^{11}$ Wasserstoff, —$NR^{15}R^{16}$ oder —$OR^{15}$ bedeutet, $R^{14}$ Wasserstoff oder Methyl ist und $R^5$ $C_1$-$C_{12}$Alkyl, Cyclohexyl, Phenyl, Tolyl oder Benzyl ist.

5. Zusammensetzungen gemäss Anspruch 1, worin die gruppen $R^{10}$, $R^{12}$, $R^{13}$ und $R^{14}$ Wasserstoff sind, $R^{11}$ —$NR^{15}R^{16}$ bedeutet und $R^5$ ein Rest der Formel V oder Phenyl ist.

6. Zusammensetzungen gemäss Anspruch 5, worin $R^{11}$ —$N(C_1$-$C_8$-$Alkyl)_2$ ist.

7. Zusammensetzungen gemäss Anspruch 6, worin $R^{11}$ —$N(C_2H_5)_2$ ist.

8. Zusammensetzungen enthaltend Komponenten a) und b) gemäss Anspruch 1 und als Komponente c) ethylenisch ungesättigte Monomere oder Präpolymere.

9. Zusammensetzungen gemäss Anspruch 8, enthaltend als Komponente c) eine Polymer-Vorstufe mit gleichen oder verschiedenen wiederkehrenden Struktureinheiten der Formel VIII

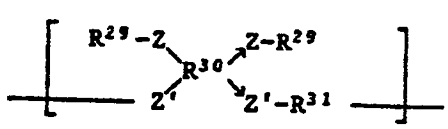
(VIII),

die beim Erwärmen zu einer thermostabilen Ringstruktur reagiert, worin
$R^{29}$ eine Rest mit einer photopolymerisierbaren olefinischen Doppelbindung ist,
$R^{30}$ ein vierwertiger aromatischer Rest nach dem Entfernen der vier funktionellen Gruppen ist, wobei je zwei funktionelle Gruppen benachbart sind und die Pfeile für Strukturisomerie stehen,
$R^{31}$ einen zweiwertigen aliphatischen, cycloaliphatischen oder ein- oder mehrkernig-aromatischen Rest bedeutet, wobei aromatische Reste $R^{31}$ in Orthostellung zur Bindung Z' eine der Gruppen —$CONH_2$ oder —COOH aufweisen können,
die Z ein kovalentes oder ionisches Bindungsglied und die Z' ein kovalentes Bindungsglied bedeuten, mit der Massgabe, dass Z und Z' beim Erwärmen der photopolymerisierbaren Zusammensetzung unter Abspaltung von $R^{29}$, gegebenenfalls zusammen mit in $R^{31}$ enthaltenen Gruppen —$CONH_2$ oder —COOH, eine thermostabile Ringstruktur ergeben.

10. Zusammensetzungen gemäss Anspruch 9, worin Komponente c) eine Polymer-Vorstufe mit wiederkehrenden Strukturelementen der Formel VIIIa ist

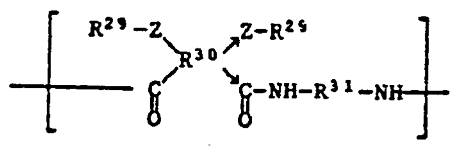

(VIIIa),

worin $R^{30}$ der vierwertige Rest einer aromatischen Tetracarbonsäure nach Entfernen von vier Carboxylgruppen ist und $R^{31}$, $R^{29}$ und Z die in Anspruch 9 angegebene Bedeutung haben.

11. Zusammensetzungen gemäss Anspruch 9, worin Komponente c) eine Polymer-Vorstufe mit wiederkehrenden Strukturelementen der Formel VIIIb ist

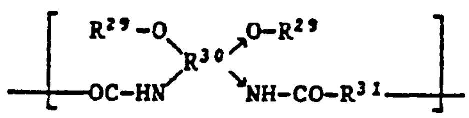

(VIIIb),

worin $R^{30}$ der Rest des 3,3'-Dihydroxybenzidins ist, die $R^{31}$ in den einzelnen wiederkehrenden Strukturelementen unabhängig voneinander den Rest der Isophthalsäure oder der 4,4'-Benzophenondicarbonsäure darstellen und $R^{29}$ die in Anspruch 9 angegebene Bedeutung hat.

12. Zusammensetzungen gemäss Anspruch 9, worin Komponente c) eine Polymer-Vorstufe mit wiederkehrenden Strukturelementen der Formel VIIIc ist

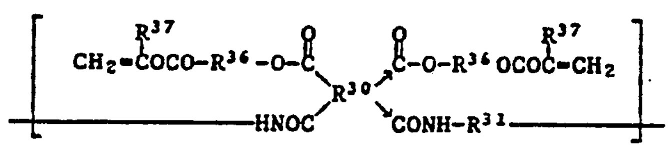

(VIIIc),

worin $R^{30}$ den Rest des Pyromellitsäuredianhydrids, eines Benzophenontetracarbonsäuredianhydrids oder ein Gemisch solcher Reste darstellt, die $R^{31}$ in den einzelnen wiederkehrenden Strukturelementen unabhängig voneinander 1,3- oder 1,4-Phenylen, den Rest des 4,4'-Diaminodiphenylethers, 4,4'-Diaminodiphenylmethans, 2,2-Bis-(4-aminophenyl)-hexafluoropropans, 4,4'-Diamino-3-carbonamidodiphenylethers oder 4,4'-Diamino-3,3'-bis-carbonamidobiphenyls darstellen, $R^{36}$ —$CH_2CH_2$— oder —$CH_2CH(OH)CH_2$— und $R^{37}$ ein Wasserstoffatom oder Methyl bedeuten.

13. Zusammensetzungen gemäss Anspruch 9, worin Komponente c) eine Polymer-Vorstufe mit wiederkehrenden Strukturelementen der Formel VIIId ist

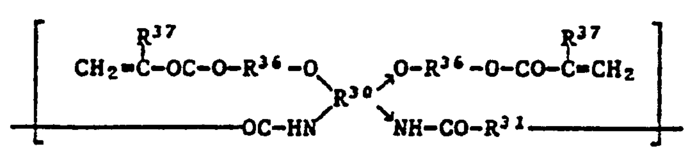

(VIIId),

worin $R^{30}$ den Rest des 3,3'-Dihydroxybenzidins, die $R^{31}$ in den einzelnen wiederkehrenden Strukturelementen

unabhängig voneinander 1,3-Phenylen oder den Rest der 4,4'-Benzophenondicarbonsäure, $R^{36}$ —$CH_2CH_2$—, —$CH_2CH_2CH_2$— oder $CH_2$-$CH(OH)$-$CH_2$— und $R^{37}$ ein Wasserstoffatom oder Methyl darstellen.

14. Zusammensetzungen gemäss Anspruch 9 enthaltend zusätzlich als Komponente d) einen Acrylsäureester, Methacrylsäureester, Allylether oder Allylester oder Teilester dieser Säuren mit einem Polyol.

15. Verfahren zur Herstellung von Abbildungen oder Schutzschichten umfassend die Schritte

i) Aufbrigen einer Schicht einer Zusammensetzung gemäss Anspruch 14 auf ein Substrat,

ii) bildmässige Belichtung des Systems,

iii) gegebenenfalls thermische Vorbehandlung, um die belichteten Stellen vorzuhärten,

iv) Entwickeln des Systems und

v) thermische Cyclisierung der Komponente c).

16. Die durch das Verfahren gemäss Anspruch 15 erhältlichen Abbildungen oder Schutzschichten.

17. Verwendung der photopolymerisierbaren Zusammensetzungen enthaltend die Komponenten a), b), c) und gegebenenfalls d) gemäss Anspruch 14 in Abbildungsverfahren auf stark streuenden oder stark reflektierenden Substraten.

## Claims

1. A composition comprising

a) a titanocene photoinitiator of the formula I

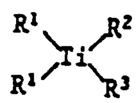

(I), and

b) a 3-ketocoumarin of the formula II

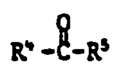

(II),

in which both $R^1$ independently of one another are unsubstituted or $C_1$-$C_8$alkyl- or $C_1$-$C_8$alkoxy-substituted cyclopentadienyl⁻, indenyl⁻ or 4,5,6,7-tetrahydroindenyl⁻ or together are a radical of the formula III

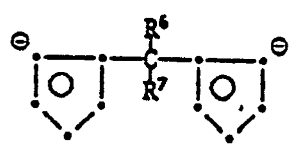

(III),

$R^6$ and $R^7$ independently of one another being hydrogen or methyl, $R^2$ is a 6-membered carbocyclic aromatic ring or a 5-membered or 6-membered heterocyclic aromatic ring, which in at least one of the two orthopositions relative to the metal-carbon bond is substituted by a fluorine atom or by a —$CF_2R$ group, R being a fluorine atom or methyl, $R^3$ is as defined for $R^2$ or, additionally, can be halogen, pseudohalogen, —$OR^8$ or —$SR^9$, $R^8$ being hydrogen, $C_1$-$C_8$alkyl, phenyl, acetyl or trifluoroacetyl and $R^9$ being $C_1$-$C_8$alkyl or phenyl, or $R^2$ and $R^3$ together form a radical of the formula IV

—Q-Y-Q— (IV),

in which Q is a 6-membered carbocyclic aromatic radical or a 5-membered or 6-membered heterocyclic aromatic radical, the two bonds each being in the ortho-position relative to the bridge Y and each metaposition relative to the bridge Y being substituted by a fluorine atom or a —$CF_2R$ group, and Y is a direct bond, —O—, —S—, —$SO_2$—, —CO—, —$CH_2$— or —$C(CH_3)_2$—, $R^4$ is a radical of the formula V

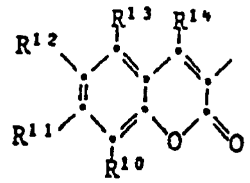

(V),

$R^5$ is $C_1$-$C_{20}$alkyl, cycloalkyl having 5-7 ring carbon atoms, phenyl or naphthyl which are unsubstituted or substituted by one to three $C_1$-$C_6$alkyl groups, $C_1$-$C_6$alkoxy groups or halogen atoms or by one diphenylamino or $C_1$-$C_6$dialkylamino group, or is $C_7$-$C_9$aralkyl, a radical $-(CH=CH)_a-C_6H_5$ or a radical of the formula V, a is 1 or 2, and $R^{10}$, $R^{11}$, $R^{12}$, $R^{13}$ and $R^{14}$ independently of one another are hydrogen, $C_1$-$C_6$-alkoxy, phenyl, tolyl, xylyl or benzyl and $R^{11}$ can additionally also be a group $-NR^{15}R^{16}$ or $-OR^{15}$, wherein $R^{15}$ and $R^{16}$ independently of one another are hydrogen or $C_1$-$C_6$alkyl, it also being possible for two or three of the radicals $R^{10}$, $R^{11}$, $R^{12}$ and $R^{13}$ together with the ring carbon atoms, to which they are attached, to form a fused ring having 5 or 6 ring atoms or a fused ring system having a 5-membered or 6-membered rings.

2. A composition according to claim 1, wherein both $R^1$ independently of one another are cyclopentadienyl which is unsubstituted or substituted by one or two methyl groups, $R^2$ and $R^3$ independently of one another are a radical of the formula VI

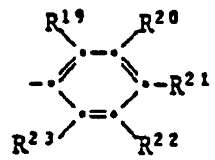

(VI),

in which $R^{19}$ is a fluorine atom or a $-CF_2R$ group and $R^{20}$, $R^{21}$, $R^{22}$ and $R^{23}$ independently of one another are a fluorine atom, a $-CF_2R$ group, hydrogen, $C_1$-$C_6$alkyl or $C_1$-$C_6$alkoxy or $R^2$ and $R^3$ together form a group of the formula IVa

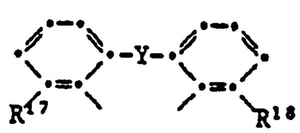

(IVa)

in which $R^{17}$ and $R^{18}$ independently of one another are a fluorine atom or a $-CF_2R$ group and Y is as defined in claim 1, or $R^3$ additionally can be a chlorine atom or a cyanide group.

3. A composition according to claim 1, wherein $R^1$ and $R^2$ independently of one another are cyclopentadienyl or methylcyclopentadienyl, and $R^3$ and $R^4$ independently of one another are a radical of the formula VII

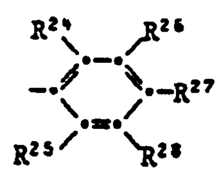

(VII),

in which $R^{24}$ and $R^{25}$ independently of one another are a fluorine atom or a $-CF_3$ group and $R^{26}$, $R^{27}$ and $R^{28}$ independently of one another are hydrogen, a fluorine atom or a $-CF_3$ group.

4. A composition according to claim 1, wherein the groups $R^{10}$, $R^{12}$ and $R^{13}$ are hydrogen, $R^{11}$ is hydrogen, $-NR^{15}R^{16}$ or $-OR^{15}$, $R^{14}$ is hydrogen or methyl and $R^5$ is $C_1$-$C_{12}$alkyl, cyclohexyl, phenyl, tolyl or benzyl.

5. A composition according to claim 1, wherein the groups $R^{10}$, $R^{12}$, $R^{13}$ and $R^{14}$ are hydrogen, $R^{11}$ is $-NR^{15}R^{16}$ and $R^5$ is a radical of the formula V or phenyl.

6. A composition according to claim 5, wherein $R^{11}$ is $-N(C_1$-$C_6alkyl)_2$.

7. A composition according to claim 6, wherein $R^{11}$ is $-N(C_2H_5)_2$.

8. A composition comprising the components a) and b) according to claim 1 and, as a component c), ethylenically unsaturated monomers or prepolymers.

9. A composition according to claim 8, containing, as component c), a polymer precursor which has identical or different recurring structural units of the formula VIII

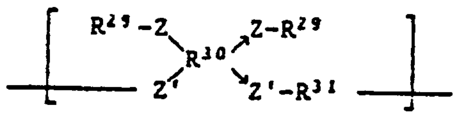 (VIII),

and reacts on heating to give a thermally stable ring structure, in which formula $R^{29}$ is a radical having a photopolymerizable olefinic double bond, $R^{30}$ is a tetravalent aromatic radical after removal of the four functional groups, two functional groups in each case being adjacent and the arrows representing structural isomerism, $R^{13}$ is a divalent aliphatic, cycloaliphatic or mononuclear or polynuclear aromatic radical, it being possible for aromatic radicals $R^{31}$ to carry one of the groups —$CONH_2$ or —COOH in the ortho-position relative to the bond Z', the Z are a covalent or ionic bond element and the Z' are a covalent bond element, with the proviso that, on heating of the photopolymerizable composition, Z and Z', if appropriate together with —$CONH_2$ or —COOH groups contained in $R^{31}$, give a thermally stable ring structure, with elimination of $R^{29}$.

10. A composition according to claim 9, wherein component c) is a polymer precursor having recurring structural elements of the formula VIIIa

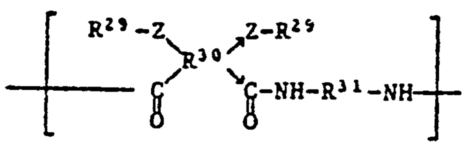 (VIIIa).

in which $R^{30}$ is the tetravalent radical of an aromatic tetracarboxylic acid after the removal of four carboxyl groups and $R^{31}$, $R^{29}$ and Z are as defined in claim 9.

11. A composition according to claim 9, wherein component c) is a polymer precursor having recurring structural elements of the formula VIIIb

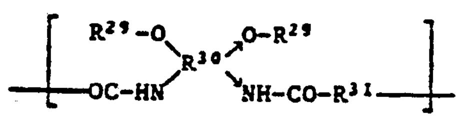 (VIIIb),

in which $R^{30}$ is the radical of 3,3'-dihydroxybenzidine, the $R^{31}$ radicals in the individual recurring structural elements independently of one another are the radical of isophthalic acid or of 4,4'-benzophenonedicarboxylic acid and $R^{29}$ is as defined in claim 9.

12. A composition according to claim 9, wherein component c) is a polymer precursor having recurring structural elements of the formula VIIIc

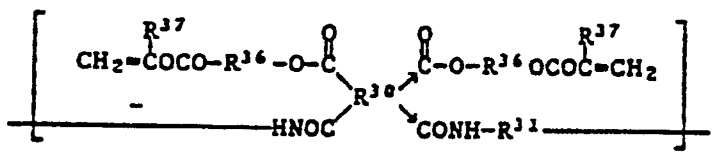 (VIIIc),

in which $R^{30}$ is the radical of pyromellitic dianhydride, a benzophenonetetracarboxylic dianhydride or a mixture of such radicals, the $R^{31}$ radicals in the individual recurring structural elements independently of one another are 1,3- or 1,4-phenylene, the radical of 4,4'-diaminodiphenyl ether, of 4,4'-diaminodiphenylmethane, of 2,2-bis-(4-aminophenyl)-hexafluoropropane, of 4,4'-diamino-3-carbonamidodiphenyl ether or of 4,4'-diamino-3,3'-bis-carbonamidodiphenyl, $R^{36}$ is —$CH_2CH_2$— or —$CH_2CH(OH)CH_2$— and $R^{37}$ is a hydrogen atom or methyl.

13. A composition according to claim 9, wherein component c) is a polymer precursor having recurring structural elements of the formula VIIId

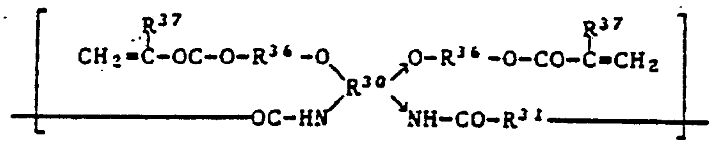

(VIIId),

in which $R^{30}$ is the radical of 3,3'-dihydroxybenzidine, the $R^{31}$ radicals in the individual recurring structural elements independently of one another are 1,3-phenylene or the radical of 4,4'-benzophenonedicarboxylic acid, $R^{36}$ is $-CH_2CH_2-$, $-CH_2$-$CH_2$-$CH_2-$ or $CH_2CH(OH)$-$CH_2-$ and $R^{37}$ is a hydrogen atom or methyl.

14. A composition according to claim 9, additionally containing, as a component d), an acrylic acid ester, methacrylic acid ester, allyl ether or allyl ester or partial esters of these acids with a polyol.

15. A process for producing images or protective layers, comprising the steps of

i) applying a layer of a composition according to claim 14 to a substrate,

ii) imagewise exposure of the system,

iii) if necessary a thermal pretreatment, in order to pre-harden the exposed areas,

iv) developing the system and

v) thermally cyclizing the component c).

16. The images or protective layers obtainable by the process according to claim 15.

17. The use of the photopolymerizable composition containing components a), b), c) and, if appropriate, d) according to claim 14 in imaging processes on substrates which are strongly scattering or strongly reflecting.

**Revendications**

1. Compositions qui contiennent :

a) un titanocène photo-inducteur de formule I ci-dessous

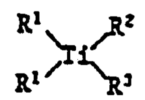

(I)

et

b) une 3-cétocoumarine de formule II

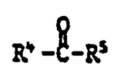

(II)

formules dans lesquelles les deux $R^1$ représentent chacun, indépendamment l'un de l'autre, un radical cyclopentadiényle$^{\ominus}$, indényle$^{\ominus}$ ou 4,5,6,7-tétrahydroindényle$^{\ominus}$ sans substituants ou avec des alkyles ou alcoxy en $C_1$-$C_6$, ou bien forment ensemble un radical de formule III :

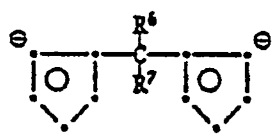

(III)

$R^6$ et $R^7$ étant chacun, indépendamment l'un de l'autre, l'hydrogène ou le groupe méthyle, $R^2$ représente un cycle aromatique carbocyclique à 6 chaînons ou un cycle aromatique hétérocyclique à 5 ou 6 chaînons avec un atome de fluor ou un groupe $-CF_2R$ à l'une au moins des deux positions ortho par rapport à la liaison métal-carbone, R étant un atome de fluor ou le groupe éthyle, $R^3$ a l'une des significations données pour $R^2$ ou peut être encore un halogène, un pseudohalogène ou un groupe $-OR^8$ ou $-SR^9$, $R^8$ étant l'hydrogène, un alkyle en $C_1$-$C_6$ ou un groupe phényle, acétyle ou trifluoroacétyle et $R^9$ un alkyle en $C_1$-$C_6$ ou un phényle, ou bien $R^2$ et $R^3$ forment ensemble un radical de formule IV :

$$-Q\text{-}Y\text{-}Q- \quad (IV)$$

Q désignant un radical aromatique carbocyclique à 6 chaînons ou aromatique hétérocyclique à 5 ou 6 chaînons, dont les deux liaisons sont chacune à la position ortho par rapport au pont Y et les positions méta par rapport à ce pont sont chacune occupées par un atome de fluor ou un groupe $—CF_2R$, et Y désignant une liaison directe ou bien —O—, —S—, $—SO_2—$, —CO—, $—CH_2—$ ou $—C(CH_3)_2—$,
$R^4$ représente un radical de formule V :

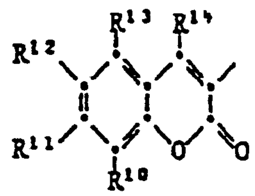

(V) et

$R^5$ un alkyle en $C_1$-$C_{20}$, un cycloakyle avec de 5 à 7 atomes de carbone dans le cycle, un phényle ou un naphtyle éventuellement substitués par un à trois alkyles ou alcoxy en $C_1$-$C_6$ ou atomes d'halogènes ou bien par un groupe diphénylamino ou $C_1$-$C_6$-dialkylamino, un aralkyle en $C_7$-$C_9$, un radical $—(CH=CH)_a$-$C_6H_5$ ou un radical de formule V ci-dessus, a étant le nombre 1 ou 2, $R^{10}$, $R^{11}$, $R^{12}$, $R^{13}$ et $R^{14}$ désignant chacun, indépendamment les uns des autres, l'hydrogène, un alkyle ou un alcoxy en $C_1$-$C_6$, ou encore un phényle, un tolyle, un xylyle ou un benzyle, $R^{11}$ pouvant être aussi un groupe $—NR^{15}R^{16}$ ou $—OR^{15}$, $R^{15}$ ou $R^{16}$ étant chacun, indépendamment l'un de l'autre, l'hydrogène ou un alkyle en $C_1$-$C_6$, et deux ou trois des radicaux $R^{10}$, $R^{11}$, $R^{12}$ et $R^{13}$ pouvant encore former ensemble et avec les atomes de carbone cycliques auxquels ils sont liés un cycle condensé à 5 ou 6 atomes dans le cycle ou un système cyclique condensé à cycles pentagonaux ou hexagonaux.

2. Compositions selon la revendication 1 dans lesquelles les deux $R^1$ sont chacun, indépendamment l'un de l'autre, un radical cyclopentadiényle sans substituants ou avec un deux groupes méthyle, et $R^2$ et $R^3$ sont chacun, indépendamment l'un de l'autre, un radical de formule VI :

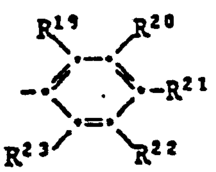

(VI)

$R^{19}$ désignant un atome de fluor ou un groupe $—CF_2R$ et $R^{20}$, $R^{21}$, $R^{22}$ et $R^{23}$, indépendamment les uns des autres, un atome de fluor, un groupe $—CF_2R$, l'hydrogène ou un alkyle ou un alcoxy en $C_1$-$C_6$, ou bien $R^2$ et $R^3$ forment ensemble un groupe de formule IVa :

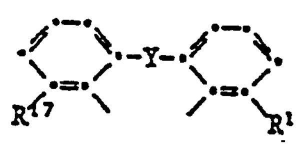

(IVa)

$R^{17}$ et $R^{18}$ désignant chacun, indépendamment l'un de l'autre, un atome de fluor ou un groupe $—CF_2R$ et Y ayant la signification donnée à la revendication 1, ou encore $R^3$ peut être également un atome de chlore ou un groupe cyanure.

3. Compositions selon la revendication 1 dans lesquelles $R^1$ et $R^2$ sont chacun, indépendamment l'un de l'autre, le radical cyclopentadiényle ou méthylcyclopentadiényle et $R^3$ et $R^4$ sont chacun, indépendamment l'un de l'autre, un radical de formule VII :

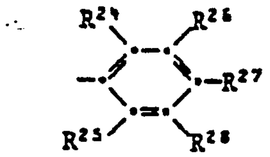

(VII)

$R^{24}$ et $R^{25}$ désignant chacun, indépendamment l'un de l'autre, un atome de fluor ou un groupe —$CF_3$ et $R^{26}$, $R^{27}$ et $R^{28}$, indépendamment les uns des autres, un atome d'hydrogène ou de fluor ou un groupe —$CF_3$.

4. Compositions selon la revendication 1 dans lesquelles $R^{10}$, $R^{12}$ et $R^{13}$ sont l'hydrogène, $R^{11}$ est l'hydrogène ou un groupe —$NR^{15}R^{16}$ ou —$OR^{15}$, $R^{14}$ l'hydrogène ou le groupe méthyle et $R^5$ un alkyle en $C_1$-$C_{12}$ ou le groupe cyclohexyle, phényle, tolyle ou benzyle.

5. Compositions selon la revendication 1 dans lesquelles $R^{10}$, $R^{12}$, $R^{13}$ et $R^{14}$ sont l'hydrogène, $R^{11}$ est un groupe —$NR^{15}R^{16}$ et $R^5$ un radical de formule V ou le groupe phényle.

6. Compositions selon la revendication 5 dans lesquelles $R^{11}$ est un groupe —$N(C_1$-$C_6$-alkyle$)_2$.

7. Compositions selon la revendication 5 dans lesquelles $R^{11}$ est le groupe —$N(C_2H5)_2$.

8. Compositions qui contiennent les composants a) et b) de la revendication 1 avec, comme composant c), des monomères à insaturation éthylénique ou prépolymères.

9. Compositions selon la revendication 8 qui contiennent comme composant c) un précurseur de polymère à motifs identiques ou différents de formule VIII :

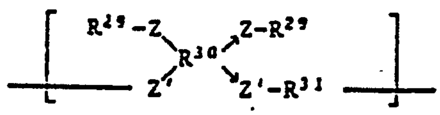

(VIII)

qui réagit à chaud en formant une structure cyclique stable à la chaleur, formule dans laquelle

$R^{29}$ représente un radical à double liaison oléfinique pouvant donner lieu à une photopolymérisation,

$R^{30}$ un radical aromatique tétravalent résultant de l'élimination des quatre groupes fonctionnels, lesquels sont voisins deux par deux et les flèches concernant l'isomérie de structure,

$R^{31}$ représente un radical divalent aliphatique, cycloaliphatique ou aromatique à 1 ou plusieurs cycles, un radical aromatique $R^{31}$ pouvant porter un groupe —$CONH_2$ ou —COOH à la position ortho par rapport à Z',

les deux Z représentent chacun un terme de liaison covalente ou ionique et les deux Z' chacun un terme de liaison covalente, avec la condition que Z et Z' donnent une structure cyclique thermostable par séparation des radicaux

$R^{29}$ par chauffage de la composition photopolymérisable, éventuellement avec le groupe —$CONH_2$ ou —COOH du radical $R^{31}$.

10. Compositions selon la revendication 9 dans lesquelles le composant c) est un précurseur de polymère à motifs de formule VIIIa :

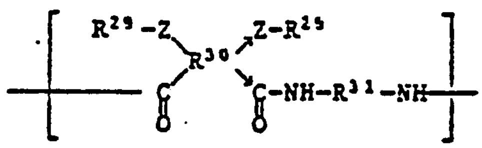

(VIIIa)

dans laquelle $R^{30}$ est le radical tétravalent d'un acide tétracarboxylique aromatique résultant de l'élimination des quatre groupes carboxyliques et $R^{31}$, $R^{29}$ et Z ont les significations qui ont été indiquées à la revendication 9.

11. Compositions selon la revendication 9 dans lesquelles le composant c) est un précurseur de polymère à motifs de formule VIIIb :

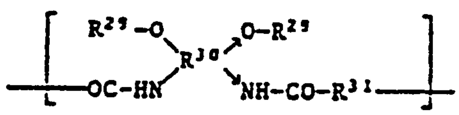

(VIIIb)

dans laquelle $R^{30}$ est le radical de la 3,3'-dihydroxybenzidine, les radicaux $R^{31}$ sont dans les divers motifs, indépendamment les uns des autres, le radical de l'acide isophtalique ou de l'acide 4,4'-benzophénonedicarboxylique, et $R^{29}$ a la signification donnée à la revendication 9.

12. Compositions selon la revendication 9 dans lequelles le composant c) est un précurseur de polymère à motifs de formule VIIIc :

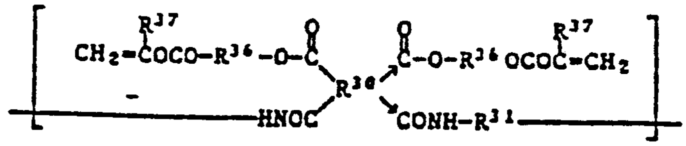

(VIIIc)

dans laquelle $R^{30}$ est le radical du dianhydride de l'acide pyrromellitique ou d'un dianhydride de l'acide benzophénonetétracarboxylique ou encore les deux à la fois, les radicaux $R^{31}$ sont dans les divers motifs, indépendamment les uns des autres, le radical 1,3- ou 1,4-phénylène ou le radical de l'éther 4,4'-diaminodiphénylique, du 4,4'-diaminodiphénylméthane, du 2,2-bis-(4-aminophényl)-hexafluoropropane, de l'éther 4,4'-diamino-3-carboxamido-diphénylique ou du 4,4'-diamino-3,3'-bis-carboxamidobiphényle, $R^{36}$ est le groupe $-CH_2CH_2-$ ou $-CH_2CH(OH)CH_2-$ et $R^{37}$ un atome d'hydrogène ou le groupe méthyle.

13. Compositions selon la revendication 9 dans lequelles le composant c) est un précurseur de polymères à motifs de formule VIIId :

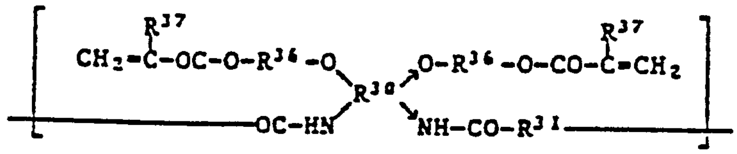

(VIIId)

dans laquelle $R^{30}$ est le radical de la 3,3'-dihydroxybenzidine, les radicaux $R^{31}$ sont dans les divers motifs, indépendamment les uns des autres, le radical 1,3-phénylène ou le radical de l'acide 4,4'-benzophénone-dicarboxylique,

$R^{36}$ est le groupe $-CH_2CH_2-$, $-CH_2CH_2CH_2-$ ou $-CH_2CH(OH)CH_2-$ et

$R^{37}$ un atome d'hydrogène ou le groupe méthyle.

14. Compositions selon la revendication 9 qui contiennent en outre comme composant d) un ester de l'acide acrylique ou méthacrylique, un éther ou un ester allylique ou un ester partiel de ces acides et d'un polyol.

15. Procédé de formation d'images ou de couches protectrices, qui comprend les opérations suivantes :

1) on dépose sur un substrat une couche d'une composition selon la revendication 14,

2) on l'irradie pour la formation d'images,

3) éventuellement on effectue un traitement thermique préalable pour prédurcir les parties qui ont été irradiées,

4) on développe et

5) on cyclise le composant c) sous l'action de la chaleur.

16. Les représentations ou reproductions et couches protectrices pouvant être obtenues par le procédé de la revendication 15.

17. L'emploi des compositions photopolymérisables comprenant les composants a), b) et c) et le cas échéant le composant d) de la revendication 14, dans la production d'images et représentations sur des substrats fortement diffractants ou fortement réfléchissants.